# EUROPEAN PATENT APPLICATION

(11) **EP 3 564 936 A1**
(43) Date of publication of application: **06.11.2019**
(21) Application number: 16925020.6
(22) Date of filing: 30.12.2016
(51) Int. Cl.: G09G 3/20

(54) **FLEXIBLE DISPLAY PANEL**

(71) Applicant: Shenzhen Royole Technologies Co., Ltd., Shenzhen, Guangdong 518172 (CN)
(72) Inventor: YUAN, Ze, Shenzhen Guangdong 518052 (CN); ZHAO, Jigang, Shenzhen Guangdong 518052 (CN)
(74) Representative: Papa, Elisabetta
(86) International application number: PCT/CN2016/113769
(87) International publication number: WO 2018/120136

(57) **Abstract**

A flexible display panel (10). The flexible display panel (10) comprises a display region (12), a lead wire region (14), and at least one electronic element (18, 182, 184). The lead wire region (14) is connected to the display region (12). The electronic element (18, 182, 184) is disposed in a corner of the lead wire region (14). A lead wire (142) used for connecting the display region (12) and an electronic element (18, 182, 184) is formed in the lead wire region (14). In the flexible panel (10), the electronic element (18, 182, 184) is disposed in the corner of the lead wire region (14), so that a bendable region in the flexible display panel (10) is larger, thereby improving freedom of product design, and eliminating the design limitation caused by the electronic element (18, 182, 184) incapable of being bent.

## Description

### FIELD

The present disclosure relates to a display field, and more particularly to a flexible display panel.

### BACKGROUND

In the related art, a flexible display panel includes a display region and a lead wire region coupled to the display region. The lead wire region is provided with an electronic element and a lead for coupling the display region to the electronic element. A part corresponding to the electronic element is generally not bendable, and thus the electronic element is arranged unsuitably, causing a negative effect on the reelable ability of the existing flexible display panels.

### SUMMARY

Embodiments of the present disclosure seek to solve at least one of the problems existing in the related art to at least some extent. Accordingly, embodiments of the present disclosure provide a flexible display panel.

In embodiments of the present disclosure, the flexible display panel includes: a display region, a lead wire region coupled to the display region, and at least one electronic element located at a corner of the lead wire region, in which a lead wire formed in the lead wire region is configured to couple the display region to the at least one electronic element.

In the flexible display panel according to the embodiment of the present disclosure, the electronic element is located at a corner of the lead wire region, such that a larger bendable region is obtained in the flexible display panel, thus improving flexibility for designing a product and removing design limitations caused by the inflexible electronic element.

In embodiments of the present disclosure, the flexible display panel includes a reelable part including a reelable display region located in the display region and a reelable lead wire region located in the lead wire region, in which a ratio of an area of the reelable display region to an area of the display region is greater than 0.5; the at least one electronic element is located outside the reelable lead wire region.

In embodiments of the present disclosure, the flexible display panel includes a flexible organic light-emitting diode (OLED).

In embodiments of the present disclosure, when the display region and the lead wire region are in a flat and unfolded manner, the flexible display panel has a rectangular shape, the display region has a rectangular shape and includes a first connecting edge and a second connecting edge vertically connected to the first connecting edge, and the first and second connecting edges are coupled to the lead wire region.

In embodiments of the present disclosure, the ratio is greater than 2/3.

In embodiments of the present disclosure, the ratio is 1.

In embodiments of the present disclosure, at least one bundle of lead wires exist, and the lead wires in the same bundle have a same length.

In embodiments of the present disclosure, the bundle of lead wires include: a plurality of first straight line segments coupled to the display region and arranged in parallel, a plurality of oblique line segments connected to the plurality of first straight line segments and arranged in an one-end gathering manner, a plurality of polygonal line segments connected to the plurality of oblique line segments, and a plurality of second straight line segments connected to the plurality of polygonal line segments and arranged in parallel, in which a width of an interval between two adjacent first straight line segments is greater than a width of an interval between two adjacent second straight line segments.

In embodiments of the present disclosure, when the display region and the lead wire region are in a flat and unfolded manner, the flexible display panel has a rectangular shape, the display region has a rectangular shape and includes two first connecting edges and a second connecting edge vertically connected to the first connecting edge, the second connecting edge is coupled to the lead wire region, the reelable part is away from one of the first connecting edges, the electronic element is provided outside the second connecting edge, the flexible display panel further includes two driving circuit units and each of the driving circuit units is located outside each of the first connecting edges, the lead wires are configured to couple the second connecting edge and the two driving circuit units to the electronic element, and the lead wires are gradually gathered into a bundle starting from ends connected to the second connecting edge and the two driving circuit units to ends connected to the electronic element.

In embodiments of the present disclosure, the electronic element is located outside a first region formed by extension lines of two first connecting edges and a second region formed by extension lines of two second connecting edges.

In embodiments of the present disclosure, when the display region and the lead wire region are in a flat and unfolded manner, the flexible display panel has a rectangular shape, the display region has a rectangular shape and includes two first connecting edges and a second connecting edge vertically connected to the first connecting edge, the second connecting edge is coupled to the lead wire region, the reelable part is located between the two first connecting edges, the flexible display panel includes two electronic elements arranged outside the second connecting edge, the flexible display panel further includes two driving circuit units and each of the driving circuit units is located outside each of the first connecting edges, two bundles of the lead wires exist, each bundle of lead wires are configured to couple a part of the second connecting edge and one of the two driving circuit units to one of the two electronic elements, and each bundle of the lead wires are gradually gathered into a bundle starting from ends connected to the second connecting edge and the driving circuit unit to ends connected to the electronic element.

In embodiments of the present disclosure, the two electronic elements are located outside a first region formed by extension lines of two first connecting edges and a second region formed by extension lines of two second connecting edges.

In embodiments of the present disclosure, when the display region and the lead wire region are in a flat and unfolded manner, the flexible display panel has a rectangular shape, the display region has a rectangular shape and includes a first connecting edge and a second connecting edge vertically connected to the first connecting edge, the first and second connecting edges are coupled to the lead wire region, the reelable part is away from one second connecting edge, the at least one electronic element includes a first electronic element arranged outside the first connecting edge and a second electronic element arranged outside the second connecting edge, two bundles of the lead wires exist, one bundle of lead wires are configured to couple the first connecting edge to the first electronic element and are gradually gathered into a bundle starting from ends connected to the first connecting edge to ends connected to the first electronic element, and the other bundle of lead wires are configured to couple the second connecting edge to the second electronic element and are gradually gathered into a bundle starting from ends connected to the second connecting edge to ends connected to the second electronic element.

Additional aspects and advantages of embodiments of present disclosure will be given in part in the following descriptions, become apparent in part from the following descriptions, or be learned from the practice of the embodiments of the present disclosure.

### BRIEF DESCRIPTION OF THE DRAWINGS

These and other aspects and advantages of embodiments of the present disclosure will become apparent and more readily appreciated from the following descriptions made with reference to the drawings, in which:
Fig. 1 is a schematic diagram of a flexible display panel according to an embodiment of the present disclosure.
Fig. 2 is a schematic diagram of a flexible display panel according to another embodiment of the present disclosure.
Fig. 3 is a schematic diagram of a flexible display panel according to a further embodiment of the present disclosure.
Fig. 4 is a schematic diagram of a flexible display panel according to a still further embodiment of the present disclosure.
Fig. 5 is a schematic diagram of a lead wire according to an embodiment of the present disclosure.
Fig. 6 is a schematic diagram of a flexible display panel according to a further embodiment of the present disclosure.

### Reference numerals:

flexible display panel 10, display region 12, first connecting edge 122, second connecting edge 124, lead wire region 14, lead wire 142, first straight line segment 1422, oblique line segment 1424, polygonal line segment 1426, second straight line segment 1428, reelable part 16, reelable display region 162, reelable lead wire region 164, electronic element 18, first electronic element 182, second electronic element 184, driving circuit unit 20, circuit board 22.

### DETAILED DESCRIPTION

Reference will be made in detail to embodiments of the present disclosure. The same or similar elements and the elements having same or similar functions are denoted by like reference numerals throughout the descriptions. The embodiments described herein with reference to drawings are explanatory, and used to generally understand the present disclosure. The embodiments shall not be construed to limit the present disclosure.

In the specification, it is to be understood that terms such as "central", "longitudinal", "lateral", "length", "width", "thickness", "upper", "lower", "front", "rear", "left", "right", "vertical", "horizontal", "top", "bottom", "inner", "outer", "clockwise" and "counterclockwise" should be construed to refer to the orientation as then described or as shown in the drawings under discussion. These relative terms are for convenience of description and do not require that the present disclosure be constructed or operated in a particular orientation. In addition, terms such as "first" and "second" are used herein for purposes of description and are not intended to indicate or imply relative importance or significance or to imply the number of indicated technical features. Thus, the feature defined with "first" and "second" may include one or more of this feature. In the description of the present disclosure, unless specified otherwise, "a plurality of' means two or more than two.

In the present diclosure, unless specified or limited otherwise, the terms "mounted", "connected", "coupled" and the like are used broadly, and may be, for example, fixed connections, detachable connections, or integral connections; may also be mechanical or electrical connections; may also be direct connections or indirect connections via intervening structures; may also be inner communications of two elements, which can be understood by those skilled in the art according to specific situations.

In the present disclosure, unless specified or limited otherwise, a structure in which a first feature is "on" or "below" a second feature may include an embodiment in which the first feature is in direct contact with the second feature, and may also include an embodiment in which the first feature and the second feature are not in direct contact with each other, but are contacted via an additional feature formed therebetween. Furthermore, a first feature "on", "above" or "on top of' a second feature may include an embodiment in which the first feature is right or obliquely "on", "above" or "on top of' the second feature, or just means that the first feature is at a height higher than that of the second feature; while a first feature "below", "under" or "on bottom of' a second feature may include an embodiment in which the first feature is right or obliquely "below", "under" or "on bottom of' the second feature, or just means that the first feature is at a height lower than that of the second feature.

Various embodiments and examples are provided in the following description to implement different structures of the present disclosure. In order to simplify the present disclosure, certain elements and settings will be described. However, these elements and settings are only by way of example and are not intended to limit the present disclosure. In addition, reference numerals may be repeated in different examples in the present disclosure. This repeating is for the purpose of simplification and clarity and does not refer to relations between different embodiments and/or settings. Furthermore, examples of different processes and materials are provided in the present disclosure. However, it would be appreciated by those skilled in the art that other processes and/or materials may be also applied.

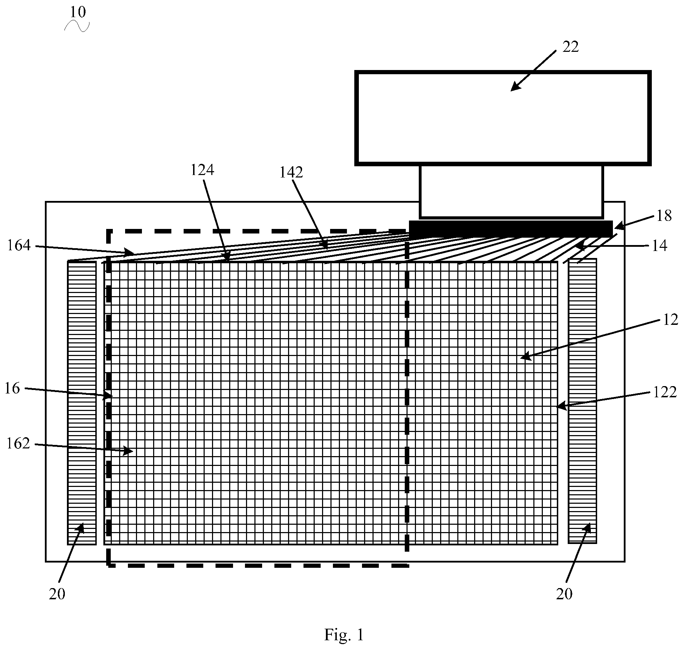

With reference to Fig. 1, a flexible display panel 10 according to an embodiment of the present disclosure includes a display region 12, a lead wire region 14, and at least one electronic element 18. The lead wire region 14 is coupled to the display region 12. The electronic element 18 is located at a corner of the lead wire region 14. A lead wire 142 formed in the lead wire region 14 is configured to couple the display region 12 to the electronic element 18.

In the flexible display panel 10 according to the embodiment of the present disclosure, the electronic element 18 is located at the corner of the lead wire region 14, such that a larger bendable region is obtained in the flexible display panel 10, thus improving flexibility for designing a product and removing design limitations caused by the inflexible electronic element 18.

It will be appreciated that the display region 12 may include a plurality of display pixels that are driven or controlled by the electronic element 18 or a driving circuit coupled to display region 12. The electronic element 18 may be a driving chip. The driving circuit may be a gate driver on array (GOA) circuit or the like. In the flexible display panel 10, the region where the driving chip or cured glue is present cannot be bent. The lead wire 142 is configured to transfer signals between the display region 12 and electronic element 18. The flexible display panel 10 may include a circuit board 22. The electronic element 18 is disposed on the circuit board 22.

In some embodiments of the present disclosure, the flexible display panel 10 includes a reelable part 16. The reelable part 16 includes a reelable display region 162 located in the display region 12 and a reelable lead wire region 164 located in the lead wire region 14. A ratio of an area of the reelable display region 162 to an area of the display region 12 is greater than 0.5. The electronic element 18 is located outside the reelable lead wire region 164.

Specifically, the reelable part 16 is a part defined by a frame with dotted lines as shown in the figures. The reelable part 16 defines a region where a bending axis can be provided, and the flexible display panel 10 can be curled around the bending axis. In this way, by locating the electronic element 18 at a corner, more than half of the display region may be constructed as the reelable display region which may be bent or curled.

In some embodiments of the present disclosure, the flexible display panel 10 includes a flexible organic light-emitting diode (OLED).

Specifically, the flexible OLED has advantages of low power dissipation and a reelable ability.

In some embodiments of the present disclosure, when the display region 12 and the lead wire region 14 are in a flat and unfolded manner, the flexible display panel 10 has a rectangular shape. The display region 12 has a rectangular shape and includes a first connecting edge 122 and a second connecting edge 124 vertically connected to the first connecting edge 122. The first connecting edge 122 and the second connecting edge 124 are coupled to the lead wire region 14.

In above manner, the electronic element 18 is configured to drive or control the display region 12 to display via the lead wire 142.

In some embodiments of the present disclosure, the ratio of the area of the reelable display region 162 to that of the display region 12 is greater than 2/3.

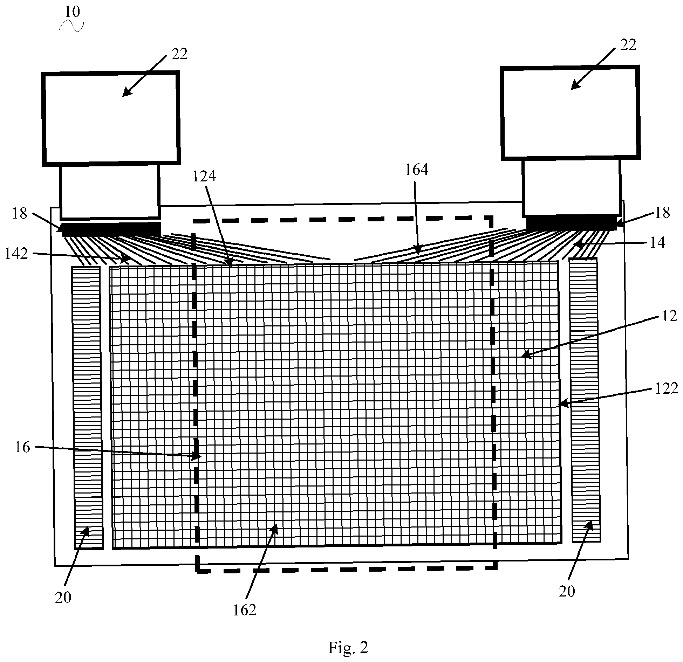

For example, as shown in Fig. 2, by suitably arranging the electronic elements 18, the proportion of the reelable display region 162 with respect to the display region 12 may be increased, and thus a variety of positions of the bending axis can be selected.

In some embodiments of the present disclosure, the ratio of the area of the reelable display region 162 to that of the display region 12 is 1.

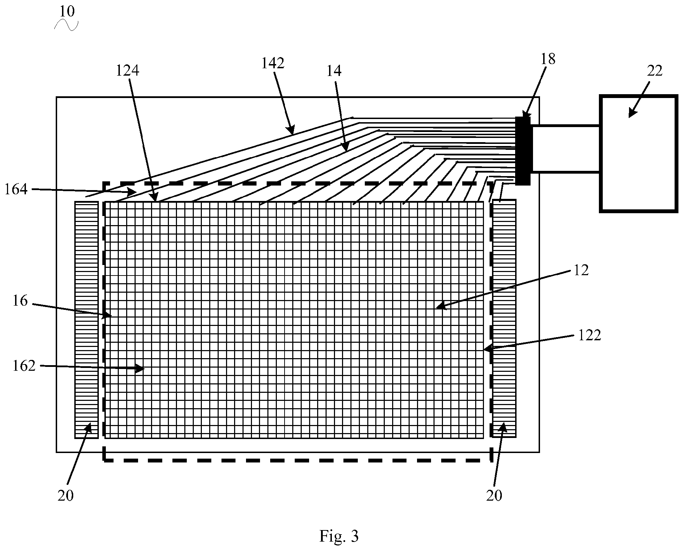

For example, as shown in Fig. 3, by suitably arranging the electronic elements 18, the bending axis may be arranged in the display region 12 or the reelable wire region 164.

In some embodiments of the present disclosure, at least one bundle of lead wires 142 exist, and the lead wires 142 in the same bundle have a same length.

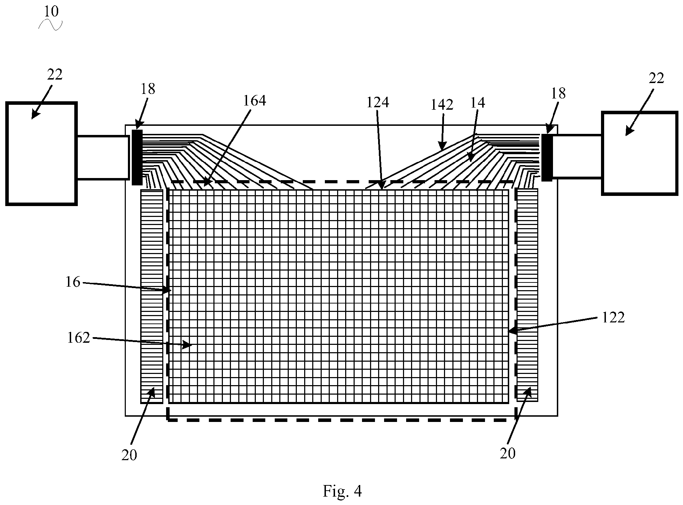

Specifically, the lead 142 is configured to transfer signals between the display region 12 and electronic element 18. On this basis, in order to ensure that the signal is transferred synchronously, path lengths of the lead wires 142 of the same bundle are identical, i.e., the length is the same. For example, as shown in Fig. 2 and Fig. 4, the flexible display panel 10 includes two bundles of lead wires 142, and the lengths of a plurality of lead wires 142 in each bundle are equal.

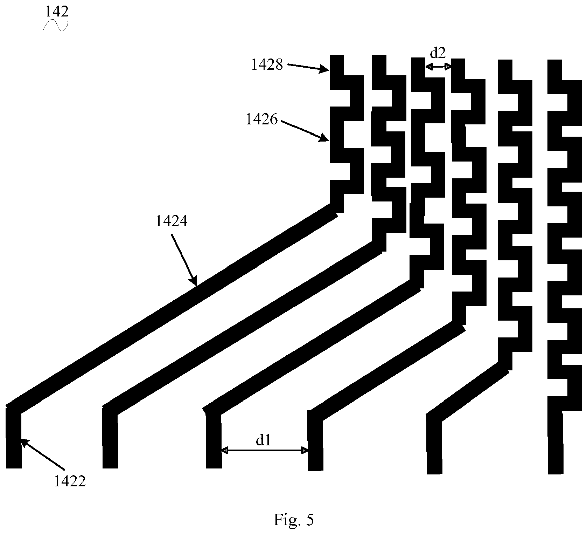

As shown in Fig. 5, in some embodiments of the present disclosure, the bundle of lead wires 142 includes a plurality of first straight line segments 1422, a plurality of oblique line segments 1424, a plurality of polygonal line segments 1426 and a plurality of second straight line segments 1428. The first straight line segments 1422 are coupled to the display region 12 and arranged in parallel. The oblique line segments 1424 are connected to the first straight line segments 1422 and arranged in a one-end gathering manner. The polygonal line segment 1426 is connected to the oblique line segment 1424. One end of the second straight line segment 1428 is connected to the polygonal line segment 1426 and arranged in parallel with other second straight line segments 1428. The other end of the second straight line segment 1428 is connected to electronic element 18. A width d1 of an interval between two adjacent first straight line segments 1422 is greater than a width d2 of an interval between two adjacent second straight line segments 1428.

In this way, the lead wires 142 can be gradually gathered and connected to the electronic element 18, thus reducing the space occupied. The lead wire 142 is bent and folded many times in the polygonal line segment 1426, such that the polygonal line segment 1426 may contain a relative long length of the lead wire 142. Moreover, in the same bundle of the lead wires 142, lengths of the polygonal line segments 1426 of different lead wires 142 may be different, specifically, should be set according to the arrangement of the electronic elements 18, thus suitably arranging the lead wires 142.

It can be understood that in order to increase the area of the region where the bending axis can be provided and to improve the flexibility of the product design, the electronic element 18 is generally located in the corner of the flexible display panel 10, and thus the oblique line segments 1424 are gathered toward the electronic element 18.

Alternatively, the polygonal line segments 1426 are located outside an extension line of the bending axis.

The polygonal line segment 1426 may contain corners, horizontal line segments, and vertical line segments. If the polygonal line segment 1426 is located on the extension line of the bending axis, a lateral stress may be applied to the lead wire 142 during bending, resulting in a negative effect on the lead wire 142.

In embodiments of the present disclosure, the arrangement of the lead wires 142 is corresponding to the asymmetric arrangement of the electronic elements 18, such that it can be ensured that every lead wire 142 has a same length and the load is the same without increasing the complexity of the design and the difficulty of integration of the process.

It should be noted that the structure of the lead wire 142 as shown in Fig. 5 is only one design of the lead wire 142. In other embodiments, the lead wire 142 may also be formed in other bending and arranging manners as needed.

In some embodiments of the present disclosure, when the display region 12 and the lead wire region 14 are in a flat and unfolded manner, the flexible display panel 10 has a rectangular shape, the display region 12 has a rectangular shape and includes two first connecting edges 122 and a second connecting edge 124 vertically connected to the first connecting edge. The second connecting edge 124 is coupled to the lead wire region 14. The reelable part 16 is away from one of the first connecting edge 122. The electronic element 18 is provided outside the second connecting edge 124. The flexible display panel 10 further includes two driving circuit units 20 and each of the driving circuit units 20 is located outside each of the first connecting edges 122. The lead wires 142 are configured to couple the second connecting edge 124 and the two driving circuit units 20 to the electronic element 18. The lead wires 142 are gradually gathered into a bundle starting from ends connected to the second connecting edge 124 and the two driving circuit units 20 to ends connected to the electronic element 18.

For example, as shown in Fig. 1, the electronic element 18 may be located in the upper right corner of the flexible display panel 10 and arranged in parallel to the second connecting edge 124. The reelable display region 162 is the left haft part of the display region 12.

In this way, an area of the region where a bending axis can be provided is increased.

In some embodiments of the present disclosure, the electronic element 18 is located outside a first region formed by extension lines of two first connecting edges 122 and a second region formed by extension lines of two second connecting edges 124.

For example, as shown in Fig. 3, the electronic element 18 may be located in the upper right corner of the flexible display panel 10 and arranged in a vertical direction to the second connecting edge 124. When the flexible display panel 10 is bent, the lead wire region 14 and the electronic element 18 may be bent for 180° to the back surface of the flexible display panel 10.

In this way, the bending axis can be arranged in any position in the whole display region 12 and the reelable wire region 164.

In some embodiments of the present disclosure, when the display region 12 and the lead wire region 14 are in a flat and unfolded manner, the flexible display panel 10 has a rectangular shape. The display region 12 has a rectangular shape and includes two first connecting edges 122 and a second connecting edge 124 vertically connected to the first connecting edge 122. The second connecting edge 124 is coupled to the lead wire region 14. The reelable part 16 is located between the two first connecting edges 122. The flexible display panel 10 includes two electronic elements 18 arranged outside the second connecting edge 124. The flexible display panel 10 further includes two driving circuit units 20. Each of the driving circuit units 20 is located outside each of the first connecting edges 122. Two bundles of the lead wires 142 exist, each bundle of lead wires 142 are configured to couple a part of the second connecting edge 124 and one of the two driving circuit units 20 to one of the two electronic elements 18, and each bundle of the lead wires 142 are gradually gathered into a bundle starting from ends connected to the second connecting edge 124 and the driving circuit unit 20 to ends connected to the electronic element 18.

For example, as shown in Fig. 2, the two electronic elements 18 may be arranged in the upper right corner and the upper left corner of the flexible display panel 10, respectively. The electronic elements 18 are arranged in parallel to the second connecting edge 124. The reelable display region 162 is a middle part of the display region 12.

In this way, an area of the region where a bending axis can be provided is increased.

In some embodiments of the present disclosure, the two electronic elements 18 are located outside a first region formed by extension lines of two first connecting edges 122 and a second region formed by extension lines of two second connecting edges 124.

As shown in Fig. 4, the two electronic elements 18 may be arranged in the upper right corner and the upper left corner of the flexible display panel 10, respectively. When the flexible display panel 10 is bent, the lead wire region 14 and the electronic elements 18 may be bent for 180° to the back surface of the flexible display panel 10.

In this way, the bending axis can be arranged in any position in the whole display region 12 and the reelable wire region 14.

In some embodiments of the present disclosure, when the display region 12 and the lead wire region 14 are in a flat and unfolded manner, the flexible display panel 10 has a rectangular shape. The display region 12 has a rectangular shape and includes a first connecting edge 122 and a second connecting edge 124 vertically connected to the first connecting edge 122. The first connecting edge 122 and second connecting edge 124 are coupled to the lead wire region. The reelable part 16 is away from one second connecting edge 124. The at least one electronic element 18 includes a first electronic element 182 arranged outside the first connecting edge 122 and a second electronic element 184 arranged outside the second connecting edge 124. Two bundles of the lead wires 142 exist. One bundle of lead wires 142 are configured to couple the first connecting edge 122 to the first electronic element 182 and are gradually gathered into a bundle starting from ends connected to the first connecting edge 122 to ends connected to the first electronic element 182. The other bundle of lead wires 142 are configured to couple the second connecting edge 124 to the second electronic element 184 and are gradually gathered into a bundle starting from ends connected to the second connecting edge 124 to ends connected to the second electronic element 184.

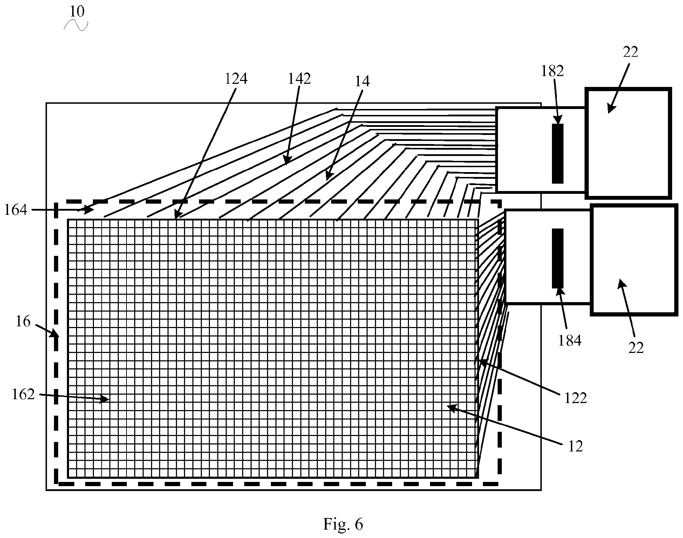

For example, as shown in Fig. 6, the first electronic element 182 and the second electronic element 184 may be arranged in the right of the flexible display panel 10 in a direction vertical to the second connecting edge 124. When the flexible display panel 10 is bent, the lead wire region 14, the first electronic element 182 and the second electronic element 184 may be bent for 180° to the back surface of the flexible display panel 10.

Specifically, the first electronic element 182 may be a gate driving chip, the second electronic element 184 may be a drain/source (SD) driving chip.

It should be noted that the flexible display panel 10 according to the embodiments of the present disclosure may include two or more bundles of lead wires 142. When there are many lead wires 142 connected to the second connecting edge 124, it is suitable to have two or more bundles of lead wires 142 included in the display panel.

The driving circuit unit 20 according to the embodiments of the present disclosure may be a GOA unit.

The display region 12 according to the embodiments of the present disclosure is not limited to being rectangular. When the display region 12 is non-rectangular, the arrangement of the lead wires 142 and the electronic element 18 may adopt the same or similar asymmetric design method. For example, the display region 12 may be a circle, a parallelogram or the like, and the electronic element 18 is located at one corner of the display region 12 to increase an area of the region where the bending axis can be provided. The arrangement of the lead wire region 14 is corresponding to the electronic element 18.

Reference throughout this specification to "an embodiment", "some embodiments", "a schematic embodiment", "an example", "a specific example" or "some examples" means that a particular feature, structure, material, or characteristic described in connection with the embodiment or example is included in at least one embodiment or example of the present disclosure. Thus, the appearances of the phrases such as "an embodiment", "some embodiments", "a schematic embodiment", "an example", "a specific example" or "some examples" in various places throughout this specification are not necessarily referring to the same embodiment or example of the present disclosure. Furthermore, the particular features, structures, materials, or characteristics may be combined in any suitable manner in one or more embodiments or examples.

It will be understood that, any process or method described in a flow chart or described herein in other manners may include one or more modules, segments or portions of codes that include executable instructions to implement the specified logic function(s) or that includes executable instructions of the steps of the progress. Although the flow chart shows a specific order of execution, it is understood that the order of execution may differ from that which is depicted. For example, the order of execution of two or more boxes may be scrambled relative to the order shown. Also, two or more boxes shown in succession in the flow chart may be executed concurrently or with partial concurrence.

The logic and/or step described in other manners herein or shown in the flow chart, for example, a particular sequence table of executable instructions for realizing the logical function, may be specifically achieved in any computer readable medium to be used by the instruction execution system, device or equipment (such as the system based on computers, the system including processors or other systems capable of obtaining the instruction from the instruction execution system, device and equipment and executing the instruction), or to be used in combination with the instruction execution system, device and equipment. As to the specification, the "computer readable medium" may be any device adaptive for including, storing, communicating, propagating or transferring programs to be used by or in combination with the instruction execution system, device or equipment. More specific examples of the computer readable medium include but are not limited to: an electronic connection (an IPM overcurrent protection circuit) with one or more wires, a portable computer enclosure (a magnetic device), a random access memory (RAM), a read only memory (ROM), an erasable programmable read-only memory (EPROM or a flash memory), an optical fiber device and a portable compact disk read-only memory (CDROM). In addition, the computer readable medium may even be a paper or other appropriate medium capable of printing programs thereon, this is because, for example, the paper or other appropriate medium may be optically scanned and then edited, decrypted or processed with other appropriate methods when necessary to obtain the programs in an electric manner, and then the programs may be stored in the computer memories.

It should be understood that each part of the present disclosure may be realized by the hardware, software, firmware or their combination. In the above embodiments, a plurality of steps or methods may be realized by the software or firmware stored in the memory and executed by the appropriate instruction execution system. For example, if it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a programmable gate array (PGA), a field programmable gate array (FPGA), etc.

Those skilled in the art shall understand that all or parts of the steps in the above exemplifying method of the present disclosure may be achieved by commanding the related hardware with programs. The programs may be stored in a computer readable storage medium, and the programs include one or a combination of the steps in the method embodiments of the present disclosure when run on a computer.

In addition, each function cell of the embodiments of the present disclosure may be integrated in a processing module, or these cells may be separate physical existence, or two or more cells are integrated in a processing module. The integrated module may be realized in a form of hardware or in a form of software function modules. When the integrated module is realized in a form of software function module and is sold or used as a standalone product, the integrated module may be stored in a computer readable storage medium.

The storage medium mentioned above may be read-only memories, magnetic disks, CD, etc.

Although explanatory embodiments have been shown and described, it would be appreciated by those skilled in the art that the above embodiments cannot be construed to limit the present disclosure, and changes, alternatives, and modifications can be made in the embodiments without departing from spirit, principles and scope of the present disclosure.

## Claims

1. A flexible display panel, comprising:
a display region,
a lead wire region coupled to the display region, and
at least one electronic element located at a corner of the lead wire region,
wherein a lead wire formed in the lead wire region is configured to couple the display region to the at least one electronic element.

2. The flexible display panel according to claim 1, wherein the flexible display panel comprises a reelable part comprising a reelable display region located in the display region and a reelable lead wire region located in the lead wire region, wherein a ratio of an area of the reelable display region to an area of the display region is greater than 0.5;
the at least one electronic element is located outside the reelable lead wire region.

3. The flexible display panel according to claim 1, wherein the flexible display panel comprises a flexible organic light-emitting diode (OLED).

4. The flexible display panel according to claim 1, wherein when the display region and the lead wire region are in a flat and unfolded manner, the flexible display panel has a rectangular shape,
the display region has a rectangular shape and comprises a first connecting edge and a second connecting edge vertically connected to the first connecting edge, and
the first connecting edge and the second connecting edge are coupled to the lead wire region.

5. The flexible display panel according to claim 2, wherein the ratio is greater than 2/3.

6. The flexible display panel according to claim 2, wherein the ratio is 1.

7. The flexible display panel according to claim 1, wherein at least one bundle of lead wires exist, and the lead wires in the same bundle have a same length.

8. The flexible display panel according to claim 7, wherein the bundle of lead wires comprise:
a plurality of first straight line segments coupled to the display region and arranged in parallel,
a plurality of oblique line segments connected to the plurality of first straight line segments and arranged in an one-end gathering manner,
a plurality of polygonal line segments connected to the plurality of oblique line segments, and
a plurality of second straight line segments connected to the plurality of polygonal line segments and arranged in parallel,
wherein a width of an interval between two adjacent first straight line segments is greater than a width of an interval between two adjacent second straight line segments.

9. The flexible display panel according to claim 2, wherein when the display region and the lead wire region are in a flat and unfolded manner, the flexible display panel has a rectangular shape,
the display region has a rectangular shape and comprises two first connecting edges and a second connecting edge vertically connected to the first connecting edge,
the second connecting edge is coupled to the lead wire region,
the reelable part is away from one of the first connecting edges,
the electronic element is provided outside the second connecting edge,
the flexible display panel further comprises two driving circuit units and each of the driving circuit units is located outside each of the first connecting edges,
the lead wires are configured to couple the second connecting edge and the two driving circuit units to the electronic element, and the lead wires are gradually gathered into a bundle starting from ends connected to the second connecting edge and the two driving circuit units to ends connected to the electronic element.

10. The flexible display panel according to claim 9, wherein the electronic element is located outside a first region formed by extension lines of two first connecting edges and a second region formed by extension lines of two second connecting edges.

11. The flexible display panel according to claim 2, wherein when the display region and the lead wire region are in a flat and unfolded manner, the flexible display panel has a rectangular shape,
the display region has a rectangular shape and comprises two first connecting edges and a second connecting edge vertically connected to the first connecting edge,
the second connecting edge is coupled to the lead wire region,
the reelable part is located between the two first connecting edges,
the flexible display panel comprises two electronic elements arranged outside the second connecting edge,
the flexible display panel further comprises two driving circuit units and each of the driving circuit units is located outside each of the first connecting edges,
two bundles of the lead wires exist, each bundle of lead wires are configured to couple a part of the second connecting edge and one of the two driving circuit units to one of the two electronic elements, and each bundle of the lead wires are gradually gathered into a bundle starting from ends connected to the second connecting edge and the driving circuit unit to ends connected to the electronic element.

12. The flexible display panel according to claim 11, wherein the two electronic elements are located outside a first region formed by extension lines of two first connecting edges and a second region formed by extension lines of two second connecting edges.

13. The flexible display panel according to claim 2, wherein when the display region and the lead wire region are in a flat and unfolded manner, the flexible display panel has a rectangular shape,
the display region has a rectangular shape and comprises a first connecting edge and a second connecting edge vertically connected to the first connecting edge,
the first and second connecting edges are coupled to the lead wire region,
the reelable part is away from one second connecting edge,
the at least one electronic element comprises a first electronic element arranged outside the first connecting edge and a second electronic element arranged outside the second connecting edge,
two bundles of the lead wires exist, one bundle of lead wires are configured to couple the first connecting edge to the first electronic element and are gradually gathered into a bundle starting from ends connected to the first connecting edge to ends connected to the first electronic element, and the other bundle of lead wires are configured to couple the second connecting edge to the second electronic element and are gradually gathered into a bundle starting from ends connected to the second connecting edge to ends connected to the second electronic element.
